## Europäisches Patentamt

## European Patent Office

## Office européen des brevets

(19)

(11) Veröffentlichungsnummer: **0 016 306**
**B1**

(12)

# EUROPÄISCHE PATENTSCHRIFT

(45) Veröffentlichungstag der Patentschrift:
08.08.84

(51) Int. Cl.³: **H 01 L 21/48, H 01 L 23/14**

(21) Anmeldenummer: **80100191.8**

(22) Anmeldetag: **16.01.80**

(54) Verfahren zum Herstellen einer mehrschichtigen Glas-Keramik-Packung für die Befestigung von Halbleitervorrichtungen.

(30) Priorität: **23.03.79 US 23113**

(43) Veröffentlichungstag der Anmeldung:
**01.10.80 Patentblatt 80/20**

(45) Bekanntmachung des Hinweises auf die Patenterteilung:
**08.08.84 Patentblatt 84/32**

(84) Benannte Vertragsstaaten:
**DE FR GB**

(56) Entgegenhaltungen:
**FR - A - 2 340 288**
**GB - A - 2 013 650**
**US - A - 2 920 971**
**US - A - 3 968 193**

**IBM TECHNICAL DISCLOSURE BULLETIN, Band 21, Oktober 1978, New York, US, S. MAGDO: "Low inductance module", Seiten 1895-1897**
**Science of Ceramics 1976, Published by the British Ceramic Society Seiten 347 bis 361**

(73) Patentinhaber: **International Business Machines Corporation, Old Orchard Road, Armonk, N.Y. 10504 (US)**

(72) Erfinder: **Narken, Bernt, 83 Albany Street, Poughkeepsie, NY 12601 (US)**
Erfinder: **Tummala, Rao Ramamahara, 20 Split Tree Drive, Wappingers Falls, NY 12590 (US)**

(74) Vertreter: **Rudack, Günter O., Dipl.-Ing. et al, c/o International Business Machines Corporation Zurich Patent Operations Säumerstrasse 4, CH-8803 Rüschlikon (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zum Herstellen einer mehrschichtigen Glaskeramik-Metall-Packung für die Befestigung von Halbleitervorrichtungen entsprechend dem Oberbegriff des Anspruchs 1.

Die der Erfindung zugrunde liegende Aufgabe besteht darin, eine verbesserte, mehrschichtige Packung für die gegenseitige Verbindung von Halbleitervorrichtungen zu schaffen, wobei eine größere Anzahl von mit integrierten Schaltungen versehene Halbleiterplättchen auf einer glaskeramischen Struktur angebracht werden sollen, die ein mehrschichtiges Verteilungsnetzwerk miteinander verbundener, aus dicken und dünnen Schichten bestehender Metallisierungsmuster aufweist. Diese glaskeramische Struktur soll dabei frei von Blasen sein, Verbindungsleitungs-Metallisierungen aufweisen und bei Temperaturen herstellbar sein, bei denen eine Verformung oder Beeinträchtigung der darunter liegenden Metallisierungsmuster und ihrer in senkrechter Richtung verlaufenden Leitungsverbindungen vermieden wird.

Beschreibung des Standes der Technik

Beim Fortschreiten der Technik integrierter Schaltungen in Richtung auf Schaltungen mit sehr hoher Integrationsdichte und hoher Leistung wird es immer mehr notwendig, eine für die gegenseitige Verbindung der integrierten Schaltkreise geeignete elektrische Packung zu schaffen, die mit den Leistungsanforderungen an die zugeordneten Schaltungen verträglich ist. Somit sind also die mit der Impedanz der Packung und dem Übersprechen auftretenden Schwierigkeiten außerordentlich kritisch zu beurteilen. Bisher bekannte, für solche Packungen verwendete Materialien haben oft nicht die geeigneten beherrschbaren dielektrischen Eigenschaften, die für die Aufnahme von Hochleistungsschaltkreisen bei sehr hoher Integrationsdichte geeignet sind.

Eine Glas-Metall-Packung hoher Qualität könnte eine Lösung für diese Schwierigkeiten darstellen. Durch einfache Veränderung der spezifischen Glaszusammensetzung lassen sich die verschiedenen Bereiche der Eigenschaften leicht einstellen und auswählen. Die Glaskeramik hat relativ hohe Festigkeit, und die Tatsache, daß sie chemisch inert und thermisch stabil ist, macht sie außergewöhnlich gut bei Verfahren einsetzbar, durch die Halbleiterplättchen auf der Oberfläche eines Substrats befestigt werden können.

Obgleich es wünschenswert ist, Glas als dielektrische Isolierschicht in mehrschichtigen Packungen mit Verbindungsleitungen einzusetzen, gibt es praktisch kaum Verfahren für die Herstellung solcher mehrschichtiger Packungen, oder aber das Ergebnis sind Produkte derart geringer Qualität, daß die Vorteile, die auf bestimmte dielektrische Eigenschaften des ausgewählten Glases zurückzuführen wären, nicht zum Tragen kommen.

Ganz allgemein gesagt ist eine der größten Schwierigkeiten bei der Herstellung mehrschichtiger Glasschichten auf die Bildung von Blasen zurückzuführen, die während des Brennens auftreten. Eine Art von Blasen ergibt sich aus der Zersetzung von auf derjenigen Oberfläche vorhandenen organischen Materialien, auf welcher die Glasschicht niedergeschlagen wird. Diese Zersetzung bewirkt die Bildung eines Gases, das durch die obere Glasschicht entweder eingefangen oder absorbiert wird. Dies hat zur Folge, daß durch diese Art von Blasenbildung Hohlräume in der Glasstruktur entstehen. Während des nachfolgenden Niederschlags einer Metallisierungsschicht bewirken diese Hohlräume oder Öffnungen öfters elektrische Kurzschlüsse, da sich in diesen Hohlräumen oder Öffnungen ebenfalls eine Metallisierung niederschlägt. In diesen Hohlräumen kann außerdem Fremdmaterial eingefangen werden, so daß die durch Verunreinigungen auftretenden Schwierigkeiten noch größer werden. Selbst wenn die Blase unbeschädigt bleibt oder in dem Glas nicht bricht, beeinträchtigt ihre Anwesenheit jedoch die Planarität der oberen Glasoberfläche und beeinträchtigt damit die weiteren Verfahrensstufen, wie z. B. photolithographische Verfahrensschritte, insbesondere mit den außergewöhnlich dünnen Leitungen, die noch beschrieben werden sollen.

Eine zweite Art von Blasen oder geschlossene Zellenstruktur verursacht bei der Herstellung von mehrschichtigen Glassubstraten ebenfalls Schwierigkeiten. Die gasförmige Atmosphäre, die das Glas während des Brennens umgibt, bildet ebenfalls Blasen in der Glasschicht. Wenn die Glasschicht in die Sinterphase eintritt, dann wird eine geschlossene Zelle oder Blase gebildet. Der Sintervorgang beginnt dann, wenn die festen Glasteilchen unter Einwirkung von Wärme erweichen und sich mit benachbarten Teilchen zu vereinigen oder zusammenzufließen beginnen. Bei der Sintertemperatur kann das Glas nicht zu einem gleichförmigen homogenen Körper verschmelzen ohne Bildung von Blasen.

Wenn benachbarte feste Glasteilchen, die beliebige geometrische Formen aufweisen, sich zu vereinigen beginnen, wird ein abgeschlossener Hohlraum gebildet. Mit anderen Worten entstehen zwischen zwei benachbarten Glasteilchen Einschnürungen, und dann werden zwischen anderen Paaren von Glasteilchen ebenfalls Einschnürungen entstehen, bis schließlich zwischen allen benachbarten Teilchen solche Einschnürungen gebildet sind. Zu diesem Zeitpunkt hat sich ein Netzwerk von gesinterten Glasteilchen gebildet unter Einschluß von Hohlräumen durch das ganze Netzwerk hindurch. Dieses Netzwerk verhindert aber die Herstellung von mehrschichtigen Glas-Metall-Substraten hoher Qualität mit den erforderlichen Impedanzwerten und der geforderten ebenen Oberfläche.

Im bisher bekannten Stand der allgemeinen Glastechnik hat man vorgeschlagen, blasenfreie Glasschichten dadurch zu bilden, daß man die Blasen bei sehr hohen Temperaturen ausdiffundieren läßt. Oft erfolgt diese Ausdiffusion in anderen gasförmigen Atmosphären. Dieses Verfahren ist jedoch für die mehrschichtigen Glas-Metall-Moduln vollkommen ungeeignet, da die für die Ausdiffusion von in der Glasschicht eingefangenen Blasen erforderlichen sehr hohen Temperaturen zuvor niedergeschlagene Metallisierungsleitungen und senkrecht verlaufende metallische Verbindungen innerhalb des Glaskörpers sowie auch die darunter liegenden Glasschichten vollkommen zerstören würden.

Eine blasenfreie Struktur ist außerdem mit hoher Qualität dadurch erzielbar, daß man das Glas in einem absoluten Vakuum brennt oder sintert. Dieses Verfahren verursacht jedoch eine beträchtliche Anzahl praktischer Schwierigkeiten, insbesondere in der Großserienfertigung, da es praktisch unmöglich ist, in dieser Umgebung zu arbeiten.

Das Aufbringen von Glasschichten durch Zerstäubung bei der Herstellung mehrschichtiger Glas-Metall-Packungen ist ein weiterer möglicher Weg. Doch hat dieses Verfahren merkliche Nachteile sowohl im Verfahren selbst als auch in der Struktur. Zunächst kann man mit einer Zerstäubung praktisch keine Glasschichten mit der erforderlichen Dicke herstellen, die manchmal erforderlich ist, um die notwendige Impedanz-Kennlinie für eine bestimmte Packung zu erzielen. Außerdem ist dieses Verfahren beim Aufbau einer Anzahl von Glasschichten mit dazwischenliegenden Metallisierungsmustern, bei denen jedes der einzelnen Metallisierungsmuster in einer einzigen Ebene liegt, nicht brauchbar.

In den US-Patentschriften 3 726 002 und 3 968 193 wurde die Herstellung eines mehrschichtigen Substrats hoher Dichte und mit sehr guten Betriebseigenschaften für die gegenseitige Verbindung von Halbleitervorrichtungen durch die folgenden Verfahrensschritte vorgeschlagen:

Herstellen einer komplexen, aus dünnen Schichten bestehenden Packung auf einem davon verschiedenen feuerfesten Substrat (beispielsweise aus Tonerde) durch Herstellen einer Anzahl blasenfreier Schichten aus Glas über dem Substrat,

Niederschlagen einer Anzahl von aus dünnen Schichten bestehenden Metallisierungsmustern über jeder niedergeschlagenen Glasschicht,

selektives Niederschlagen von in senkrechter Richtung verlaufenden leitenden Verbindungen zum Anschluß zwischen den verschiedenen Leitungsmustern und

Aufbringen einer Anzahl integrierte Schaltungen enthaltender Halbleiterplättchen auf der oberen Oberfläche der Glaspackung.

Obwohl dieses Verfahren in der Technik Eingang gefunden hat, so hat es doch den Nachteil, daß außergewöhnliche Sorgfalt und Aufmerksamkeit bei der Fertigung erforderlich sind, damit der Zusammenhalt erhalten bleibt. Es sei darauf hingewiesen, daß ein Tonerdesubstrat wegen seines hohen Wärmeausdehnungskoeffizienten, verglichen mit Silicium, die Befestigung von größeren Halbleiterplättchen nicht zuläßt.

Wie zum Beispiel in den beiden oben genannten Patentschriften ausgeführt, ist es, da ein wesentlicher Faktor bei der Bearbeitung von Glas seine Brenntemperatur ist, notwendig, die Sintertemperaturen der Gläser genau zu berücksichtigen, um eine Unterbrechung in der darunter liegenden Metallisierung zu vermeiden. Wenn also gleichartige Gläser verwendet werden, können die Sintertemperaturen die darunter liegenden Glasschichten zum Erweichen bringen mit einer entsprechenden viskosen Verformung der Glasschichten und der Gefahr einer gleichzeitigen Verschiebung der Metallisierungsmuster.

Außerdem ist immer noch die Gefahr vorhanden, daß das Glas reißt, was dazu führt, daß die Wärmeausdehnungskoeffizienten der verschiedenen Schichten in einer mehrschichtigen Glasstruktur und einer mehrschichtigen keramischen Struktur kritisch aneinander angepaßt werden müsen, was gemäß der zweitgenannten US-Patentschrift dadurch erreicht wird, daß man in der Beziehung der Spannungszustände zueinander einen Kompromiß herstellt, d. h. wenn in der sich insgesamt ergebenden Packung die Glaskomponente in einem Zustand der Kompression und die darunter liegende keramische Komponente in einem Zustand der Zugspannung ist, wodurch der Zusammenhalt der gesamten Packung verringert wird. Alle diese Schwierigkeiten werden durch die im kennzeichnenden Teil des Patentanspruchs 1 angegebenen Verfahrensmaßnahmen beseitigt. Vorteilhafte Weiterbildungen der Erfindung sind den Unteransprüchen zu entnehmen.

Die Erfindung wird nunmehr anhand von Ausführungsbeispielen in Verbindung mit den Zeichnungen im einzelnen beschrieben. In den Zeichnungen zeigt

Fig. 1 schematisch, zum Teil weggebrochen, eine mit integrierten Halbleiterschaltungen versehene Packung auf einem einzigen Substrat in perspektivischer Ansicht zur Darstellung wie das Glas-Metall-Substrat aufgebaut ist,

Fig. 2 eine Teilquerschnittsansicht längs der Linie 2-2 in Fig. 1 zur genaueren Darstellung der verschiedenen Verbindungsebenen innerhalb der Packung,

Fig. 3 eine vergrößerte Draufsicht auf den Ort eines einzelnen Halbleiterplättchens in Fig. 1 und die Art der Anschlüsse eines Halbleiterplättchens auf der auf der oberen Oberfläche des Substrats liegenden Metallisierung,

Fig. 4A—4C eine schrittweise Darstellung in Querschnittsansichten einer bevorzugten Ausführungsform der Fertigung des Glas-Metall-Substrats mit allen Verbindungsleitungen, und

Fig. 5 eine Querschnittsansicht einer weiteren Ausführungsform der obersten Ebene der Metallisierung.

### Einzelbeschreibung der Erfindung

Die Erfindung dient der Herstellung von logischen Schaltungen und Speicherschaltungen hoher Dichte und hoher Leistung auf Glas-Keramik-Substraten unter Verwendung einer Dickschicht-Technik für das unten liegende Netzwerk von Erdungs- und Stromversorgungsebenen und einer Dünnschicht-Technik für die oberen Netzwerke für die Verteilungs- und Signalebenen.

Der Ausdruck »Dickfilm-Technik« soll für dieses Anwendungsgebiet bedeuten, daß diese Schichten normalerweise aus einer aus metallischen Teilchen und einem Träger bestehenden Paste gebildet werden, die selektiv (beispielsweise durch Siebdruck) auf ein Substrat aufgebracht werden kann, und die anschließend zum Austreiben des Trägers und zum Zusammenfließen der metallischen Teilchen zum gewünschten Leitungsmuster gebrannt wird. Die dicken Schichten können dabei bis zu 0,25 mm oder mehr dick sein, doch kann ihre Stärke nach dem Brennen oder Sintern bis zu etwa 0,013 mm schrumpfen.

Bei Dünnschicht-Schaltungen bestehen die Leitungsnetzwerke oder Leitungsmuster aus dünnen metallischen Schichten mit einer Stärke zwischen 30 nm und 3000 nm, die vorzugsweise durch Niederschlag im Vakuum, wie z. B. durch Kathodenzerstäubung oder Verdampfung gebildet werden. Die dünnen Schichten können zur Herstellung der gewünschten Leitungsmuster durch geeignete Masken niedergeschlagen werden oder aber als alles überdeckende Schichten, die anschließend zur Herstellung des gewünschten Leitungsmusters selektiv geätzt werden.

Die Erfindung verwendet vorgefertigte, mehrschichtige glaskeramische Substrate, in denen in mehreren Ebenen Stromversorgungsleitungen aus Dickschicht-Leitungsmustern, vorzugsweise aus Gold, Silber oder Kupfer, eingebettet sind.

Der Ausdruck »Alpha-Cordierit-Glas-Keramik« bezieht sich in der Beschreibung und in den Patentansprüchen auf eine bevorzugte Glas-Keramik-Struktur, die aus Alpha-Cordierit (ein Silikat aus Aluminium, Eisen, Magnesium und Wasser) zu einer Mikrostruktur eines durchgehenden Netzwerkes von 2 bis 5 µm großen Kristalliten aus kleinen Mengen von Klinoenstatit mit einer zusätzlichen Cordieritphase verschmolzen und kristallisiert ist.

Weiterhin soll der in der Beschreibung und in den Ansprüchen verwendete Ausdruck »Beta-Spodumen-Glas-Keramik« (Spodumen ist ein Lithium- plus Aluminiumsilikat) auf eine andere Glas-Keramik-Struktur gerichtet sein, die aus Beta-Spodumen-Gläsern zu einer Mikrostruktur mit einem durchgehenden, kontinuierlichen Netzwerk von 2 bis 5 µm großen Kristalliten von Beta-Spodumen verschmolzen und kristallisiert ist, wobei an den Zwischengitterplätzen des Netzwerkes restliches Glas eingelagert ist, in denen fein verteilt diskrete, sekundäre 1 bis 2 µm große Kristalliten von Lithiummetasilikat fein verteilt sind.

### Herstellung mehrschichtiger Substrate

Das vorgeformte Substrat verwendet kristallisierbare Gläser vom Beta-Spodumen-Typ und vom Cordierit-Typ zur Herstellung von mehrschichtigen Glas-Keramik-Substraten, die gemeinsam damit gesinterte Leitungsmuster aus Gold, Silber oder vorzugsweise aus Kupfer enthalten. Die Substratfertigung besteht dabei aus den folgenden Verfahrensschritten:

### Schritt 1

Die Scherben der ausgewählten Glassorte werden bis zu einer durchschnittlichen Teilchengröße im Bereich von 2 bis 7 µm gemahlen. Der Mahlvorgang kann dabei in zwei Stufen erfolgen, in einem ersten trockenen oder nassen Mahlvorgang bis zu einer Teilchengröße von 400 Mesh, gefolgt von einem weiteren Mahlvorgang mit einem organischen Bindemittel und Lösungsmitteln, bis die durchschnittliche Teilchengröße so weit verringert ist, daß sie zwischen 2 und 7 µm liegt und man eine ausgießbare Trübe erhält. Man kann auch die Scherben der gewählten Glassorte in einem einzigen verlängerten Mahlvorgang mit dem Bindemittel und dem Lösungsmittel so lange mahlen, bis die gewünschte Teilchengröße erreicht ist. In diesem Fall kann das Ausfiltrieren von zu großen Teilchen noch erforderlich sein. Ein geeignetes Bindemittel ist beispielsweise ein Polyvinyl-Butyralharz mit einem Weichmacher, wie z. B. Dioctophthalat oder Dibutylphthalat. Andere geeignete Polymere sind Polyvinyl-Formal, Polyvinyl-Chlorid, Polyvinyl-Acetat oder gewisse Acrylharze. Die Beigabe eines leicht austreibbaren Lösungsmittel, wie z. B. Methanol, hat zur Folge, daß dadurch zunächst das Bindemittel gelöst wird, so daß es die einzelnen Glasteilchen benetzt und überzieht, und dient außerdem dazu, die Fließeigenschaften oder Viskosität der Trübe so einzustellen, daß sie sich gut vergießen läßt.

Ein besonders brauchbares, kristallisierbares Glas, was sich für die Zwecke der vorliegenden Erfindung einsetzen läßt, hat die nachfolgend in Gewichtsprozent angegebene Zusammensetzung:

| | |
|---|---|
| $SiO_2$ | 55,0 |
| $Al_2O_3$ | 20,56 |
| MgO | 20,00 |
| $AlPO_4$ | 3,44 |
| $B_2O_3$ | 1,00 |

Dieses Glas hat nach der Kristallisation eine Dielekrizitätskonstante von etwa 5, einen Wärmeausdehnungskoeffizienten Tce von etwa $19 \cdot 10^{-7}/°C$ im Temperaturbereich zwischen 20°C und 90°C oder ein Tce von $26 \cdot 10^{-7}/°C$ in einem Temperaturbereich von 20°C bis 300°C.

Der Wärmeausdehnungskoeffizient von $19 \cdot 10^{-7}/°C$ steigt mit einer Metallisierung aus Kupfer für die Leitungszüge bis auf einen Wert von $26 \cdot 10^{-7}/°C$ an, was eine vollkommene Anpassung an Silicium in dem Temperaturbereich ergibt, in dem die Substrate in einer Datenverarbeitungsanlage betrieben werden.

Dieses Glas kann bei der Herstellung der dünnen Schichten der glaskeramischen Packung verwendet werden und wird in der Tat dazu benutzt.

### Schritt 2

Die gemäß Schritt 1 hergestellte Trübe wird mit üblichen Verfahrensschritten vorzugsweise mit einer Rakel zu grünen, dünnen Folien verarbeitet.

### Schritt 3

Die so hergestellten, dünnen, grünen, d. h. nicht gebrannten oder gesinterten Folien werden mit einem entsprechenden Werkzeug auf die geforderten Abmessungen zurechtgeschnitten, und die erforderlichen durchgehenden Bohrungen werden hergestellt.

### Schritt 4

Eine Metallisierungspaste aus Gold, Silber oder Kupfer wird im Siebdruckverfahren in die durchgehenden Bohrungen in den einzelnen Folien eingebracht.

### Schritt 5

Auf die einzelnen grünen, d. h. ungebrannten Folien werden dann die gewünschten Leitungsmuster im Siebdruck aufgebracht.

### Schritt 6

Eine Anzahl von gemäß Schritt 5 hergestellten Folien wird dann, gegenseitig miteinander ausgerichtet, in einer Laminierpresse laminiert.

Dabei sollte die für das Laminieren verwendete Temperatur und der Druck so gewählt werden, daß die einzelnen grünen Folien so miteinander verbunden werden, daß sich ein monolithisches grünes Substrat ergibt und daß dabei die grünen Folien soweit fließen, daß sie die Leitungsmuster fest umschließen.

### Schritt 7

Die grünen Folien werden dann bei Sintertemperaturen gebrannt, wodurch das Bindemittel ausgetrieben und die Glasteilchen gesintert und gleichzeitig durch Kristallisation zu Glaskeramik umgewandelt werden, worauf dann die Metallteilchen in den Dickschichtleitungsmustern und den durchgehenden Bohrungen zu dichten metallischen Leitungen gesintert werden. Die hier gewählte glaskeramische Zusammensetzung sollte dann eine optimale Sintertemperatur haben, die zwischen 50°C und 150°C unter dem Schmelzpunkt des für die Leitungen verwendeten Metalls liegt.

Während des Sinterzyklus werden die organischen Bindemittel bei 300°C ausgetrieben, und das Austreiben des Bindemittels ist im wesentlichen abgeschlossen, bevor eine merkliche Glas-Glas-Sinterung eingetreten ist. Der Sintervorgang hat zur Folge, daß das Glasmaterial in den Glaskeramik-Zustand übergeht, wobei die so entstandenen kristallinen Phasen mehr als 80% des Volumens des Körpers einnehmen. Die Sintertemperatur soll dabei zwischen 1 und 5 Stunden eingehalten werden. Der gesinterte Körper wird dann mit einer Geschwindigkeit, die 4°C je Minute nicht überschreiten soll, auf mindestens etwa 400°C abgekühlt. Danach kann eine raschere Abkühlung vorgenommen werden.

Verwendet man Kupfer in der Metallisierungspaste, dann muß das Brennen des Substrats in einer nicht oxidierenden Atmosphäre und vorzugsweise in einer Wasserstoff-Wasser-Atmosphäre durchgeführt werden. Aus diesem Grund sollten bei der Herstellung von grünen, ungebrannten keramischen Folien verwendete organische Bindemittel in derartigen Atmosphären bei vernünftigen Temperaturen verdampft werden könen.

Dann wird eine geeignete Dünnschichtmetallisierung (z. B. Schichtenfolgen aus Chrom-Kupfer-Chrom, Cr—Cu—Cr), alles überdeckend auf dem Glas-Keramik-Dickschichtsubstrat niedergeschlagen und dann entweder durch Subtraktionsätzen oder Niederschlagen einer dünnen Metallschicht, die anschließend durch Zerstäubungsätzen entfernt wird, oder durch andere Verfahren in ein Muster von außergewöhnlich feinen Linien oder Leitungen (12 μm breit mit 12 μm breiten Abständen) auf der vorgefertigten Glas-Keramik-Struktur umgewandelt. Kupferstiftchen werden dann entweder galvanisch oder durch Verdampfung auf die Kupferleitungen aufgebracht. Daraufhin wird eine Trübe aus einem Pulver eines kristallisierbaren Glases (beispielsweise die oben angegebenen Zusammensetzung) in einem Trägermaterial, wie z. B. Terpineol bis zu einer Dicke von etwa 0,0025 mm bis etwa 0,05 mm durch Sprühen aufgebracht und anschließend an Ort und Stelle gesintert und kristallisiert. Dann wird eine zweite, aus einer Schichtenfolge Cr—Cu—Cr bestehende Metallisierung auf der Oberfläche der so gebildeten glaskeramischen Schicht niedergeschlagen, wobei die Anschlußstiftchen und die nächste Schicht aus glaskeramischem Material in gleicher Weise wie zuvor gebildet werden. Dieses Verfahren kann so lange wiederholt werden, bis die gewünschte Dünnschicht-Mehrschichtstruktur erreicht ist. Falls dünnere dielektrische Schichten, z. B. Glaskeramik, für industrielle Zwecke erforderlich sind, können sie durch Verdampfen von Glas oder glaskeramischen Materialien gebildet werden.

Diese Technik hat zwei herausragende Merkmale:

1. Da die Glaskeramik, wenn sie einmal hergestellt ist, nicht nur eine wesentlich homogene glaskeramische Struktur von der Basis bis zur Oberseite aufweist, sondern auch viel höhere Temperaturen auszuhalten vermag als bei ihrer Herstellung erforderlich waren, wird während nachfolgender Brennzyklen zur Bildung weiterer Schichten der Glaskeramik keine fließende Verformung festgestellt. Die oben erwähnte kristallisierbare Glaszusammensetzung hat eine Fließtemperatur von etwa 780°C, bei der sie zusammenschmilzt, und eine Kristallisationstemperatur von etwa 965°C, bei der sie in eine Glaskeramik umgewandelt wird, die einen Erweichungspunkt bei oberhalb 1100°C aufweist, was etwa 300°C oberhalb der Erweichungstemperatur des Glases vor der Kristallisation liegt. Daher wird die so gebildete Glaskeramik bei der weiteren Bildung zusätzlicher Überzüge aus Glaskeramik praktisch nicht beeinflußt. Man sieht ferner, daß die Erweichungs- und/oder Kristallisationstemperaturen wesentlich unter den Schmelzpunkten von Gold, Silber und Kupfer, d. h. 1061°C, 961°C und 1081°C liegen. Bei Silber soll die Kristallisation des Glases unterhalb dem Schmelzpunkt von Silber erfolgen, und dann müssen andere geeignete kristallisierbare Gläser benutzt werden, deren Schmelztemperatur und Fließtemperatur niedriger liegt, wie beispielsweise die folgende Zusammensetzung, in Gewichtsprozent:

| | |
|---|---|
| $SiO_2$ | 52,5 |
| $MgO$ | 21,5 |
| $Al_2O_3$ | 21,0 |
| $P_2O_5$ | 2,0 |
| $B_2O_3$ | 1,0 |

Das heißt ferner, daß auch keine Blasenbildung auftritt und daß die Metallisierungsleitungen nicht verzerrt werden.

2. Da die Oberflächengüte der Glaskeramiken stets besser ist als die Oberflächenqualität einer aus Tonerde bestehenden Substratbasis, lassen sich mit einer Glas-Keramik-Substratbasis wesentlich feinere Linienmetallisierungen erzielen, als dies mit einem Tonerdesubstrat möglich ist, da auf einem solchen Substrat 12 μm breite Linien nicht

hergestellt werden können.

Die Zusammensetzung des kristallisierbaren Glases kann vorzugsweise für das Dickschicht-Dielektrikum und das Dünnschicht-Dielektrikum die gleiche sein, mit einer Dielektrizitätskonstante von etwa 5 und einem Wärmeausdehnungskoeffizienten, der an den von Silicium nach der Metallisierung angepaßt ist (z. B. $19 \cdot 10^{-7}/°C$ bei 20°C bis 90°C und $26 \cdot 10^{-7}/°C$ bei 20°C bis 300°C), wobei die Sintertemperatur nicht höher liegt als 950°C. Es sei jedoch darauf hingewiesen, daß, falls erwünscht oder erforderlich, die verschiedensten Kombinationen kristallisierbarer Gläser hier eingesetzt werden können.

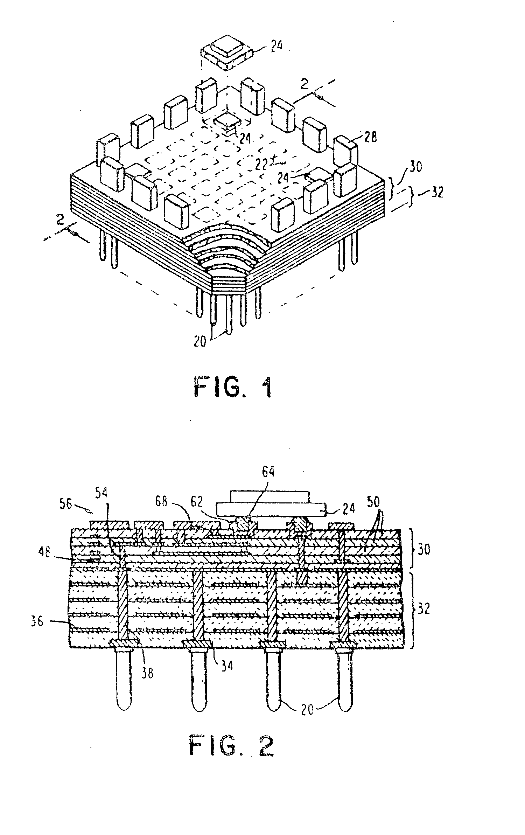

Die derzeit beste Ausführungsform der Erfindung soll nun beschrieben werden. In Fig. 1, 2 und 3 sind die konstruktiven Einzelheiten einer komplexen Struktur mit Verbindungsleitungen gezeigt, wie sie für eine Verbindung nach außen über eine Anzahl von Anschlußstiften 20 nach einer Anzahl von Punkten 22 für Halbleiterplättchen 24 notwendig sind, die an den einzelnen Punkten 22 angebracht werden können. Die Dickschicht-Metallisierung, die deutlicher aus Fig. 2 zu ersehen ist, dient der Spannungsverteilung, als Erdungsebene, als X-Y-Signalebenen und zur Weiterleitung von Versorgungsspannungen.

In dieser bevorzugten Ausführungsform wird eine Glas-Metall-Packung 30 mit einem vorgefertigten, mehrschichtigen Glas-Keramik-Substrat 32 verbunden. Eine Anzahl von auf der unteren Oberfläche des mehrschichtigen Glas-Keramik-Substrats 32 liegenden Anschlußkontakten 34 ist jeweils mit den Anschlußstiften 20 verbunden. In der bevorzugten Ausführungsform bestehen die Anschlußkontakte 34 aus mit Nickel überzogenem Wolfram, an denen dann die Anschlußstifte 20 angeschweißt sind.

Das mehrschichtige Glas-Keramik-Substrat 32 enthält eine mehrschichtige Dickschicht-Metallisierung 36 in mehreren Ebenen. Außerdem sind senkrecht verlaufende Leitungen durch das mehrschichtige glaskeramische Substrat 32 in Form von mit einem Metall ausgefüllten durchgehenden Bohrungen 38 vorgesehen. Das mehrschichtige, glaskeramische Substrat 32 enthält die Spannungsversorgungsebenen. Die Anzahl der Spannungsversorgungsebenen wird durch die Spannungserfordernisse der logischen Schaltkreisfamilie in den einzelnen Halbleiterplättchen bestimmt.

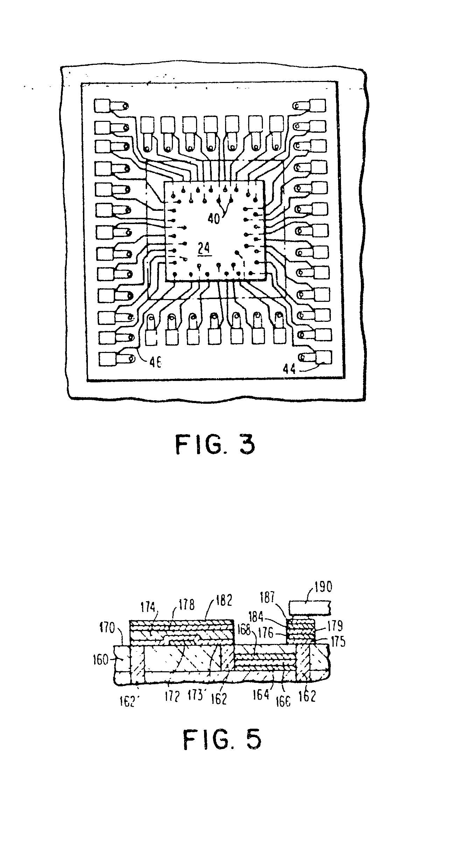

Das mehrschichtige Glas-Keramik-Substrat 32 enthält auch die Spannungsverteilungsebenen, da die die Verbindungen nach außen herstellenden Anschlußstifte 20 in einem größeren Gitter liegen als das durch die Anschlußkontakte 40 in Fig. 3 dargestellte Gitter auf der Ebene der Halbleiterplättchen. Fig. 3 zeigt ferner, mit welcher Leichtigkeit die Anschlüsse von einer Anzahl von Anschlußkontakten 44, die auf der Oberfläche der Glas-Metall-Packung 30 vorgesehen sind, nach einer Anzahl von Leitungszügen 46 hergestellt werden können. Die Leitungszüge 46 werden an sich durch Niederschlag von Metall hergestellt, jedoch können die Anschlüsse auf der
oben liegenden Oberfläche durch Anlöten von
Drähten, Thermokompressionsschweißen usw.
hergestellt werden.

Die gesamte Glas-Keramik-Metall-Packung 30
enthält außerdem die auf mehreren Ebenen angeordneten Metallisierungen 48, die durch eine
Anzahl isolierender glaskeramischer Schichten
50 gegeneinander isoliert sind. Verbindungsleitungen in senkrechter Richtung zwischen den
verschiedenen Ebenen und dem mehrschichtigen glaskeramischen Substrat 32 werden durch
eine Anzahl Stifte 54 gebildet.

In Fig. 2 ist die auf der Oberfläche liegende
Metallisierung mit dem Bezugszeichen 56 bezeichnet. Diese auf der obersten Ebene liegende
Metallisierung 56 entspricht schematisch den
Anschlußkontakten und Leitungszügen in Fig. 3
mit den Bezugszeichen 44 bzw. 46. Die Halbleiterplättchen 24 werden an vorbestimmten Leitungen durch ein Metallisierungssystem und Lötanschlüsse 62 bzw. 64 angeschlossen.

Damit eine technische Änderung durchgeführt werden kann, sind entsprechende Polster
68 in der Metallisierung 56 der obersten Ebene
vorgesehen. Grundsätzlich können diese Polster
68 aus einem Material bestehen, das weicher ist
als die Metallisierung 56 selbst. Wenn daher ein
entsprechender Druck auf die oberste Oberfläche der Metallisierung 56 im Bereich eines Polsters 68 ausgeübt wird, dann bricht die entsprechende Leitung durch. Umleitungen oder Änderungen sind dann dadurch möglich, daß beispielsweise durch Anlöten oder Anschweißen
von Drähten andere Verbindungen hergestellt
werden können. Es ist nur ein Polster 68 für derartige Änderungen dargestellt. Tatsächlich würden jedoch über die ganze oberste Ebene der
Metallisierung zahlreiche solcher kleiner Polster
68 vorgesehen sein. Diese Polster 68 können dabei aus einem elastischen Material, wie z. B. einem Polyimid-Polymeren bestehen, das die zum
Durchtrennen von Leitungen aufgewendeten
Kräfte abfängt und damit eine Beschädigung der
obersten Glasschicht verhindert, obgleich solche Polster nicht in allen Fällen unbedingt erforderlich sind.

Gemäß Fig. 5 gibt es noch ein weiteres Verfahren, um die Metallisierung der obersten Ebene an verschiedene Bedürfnisse anzupassen und
einzelne Anschlüsse wegzulassen bzw. andere
Anschlüsse vorzunehmen. Fig. 5 zeigt dabei insbesondere ein chromloses Verfahren, wobei jedoch auch einfache mechanische oder mit Laserstrahl arbeitende Trennverfahren in gleicher
Weise geeignet sind.

Die sich hier insgesamt ergebende Packung
soll dabei mit entsprechender Kühlung arbeiten,
die entsprechend der Anzahl der Halbleiterplättchen, der verbrauchten elektrischen Leistung
und der Wärmeübertragung nach den einzelnen
Wärmesenken bestimmt wird, die an den jeweiligen Halbleiterplättchen 24 angeschlossen sind.

In der bevorzugten Ausführungsform enthält
die Glas-Keramik-Metall-Packung 30 eine X- und
Y-Signalebene, eine Spannungsverteilungsebene, eine Spannungsversorgungsebene und als
oberste Ebene eine Metallisierung für Verbindungen und Veränderungen von Leitungsführungen.

Um eine möglicht gute Ausnutzung und einen
möglichst guten Wirkungsgrad einer einzigen
ebenen Oberfläche zu erzielen, werden X- und
Y-Ebenen eingesetzt. Das heißt, in einer Ebene
verlaufen praktisch alle Metallisierungsleitungen
in einer Richtung und in der anderen dazu orthogonalen Ebene sind die Metallisierungsleitungen
in einer dazu rechtwinklig verlaufenden Richtung
niedergeschlagen.

### Schritt 1

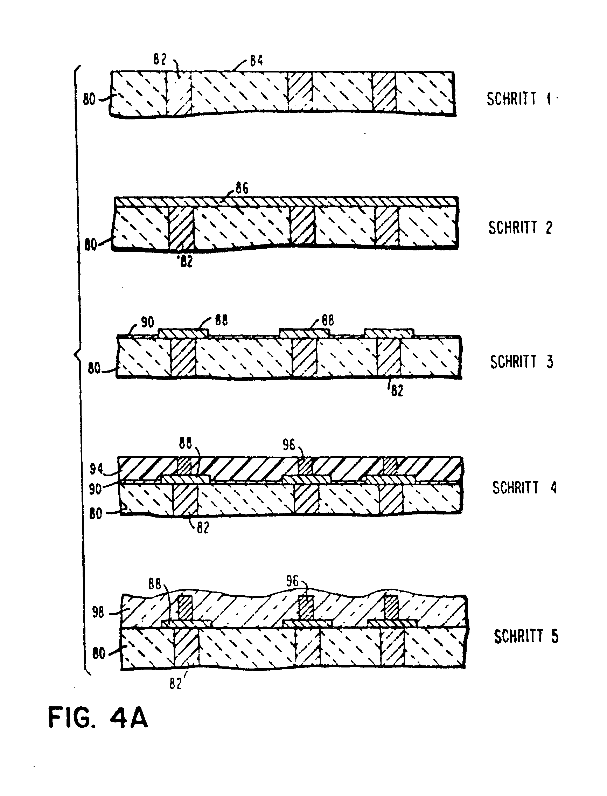

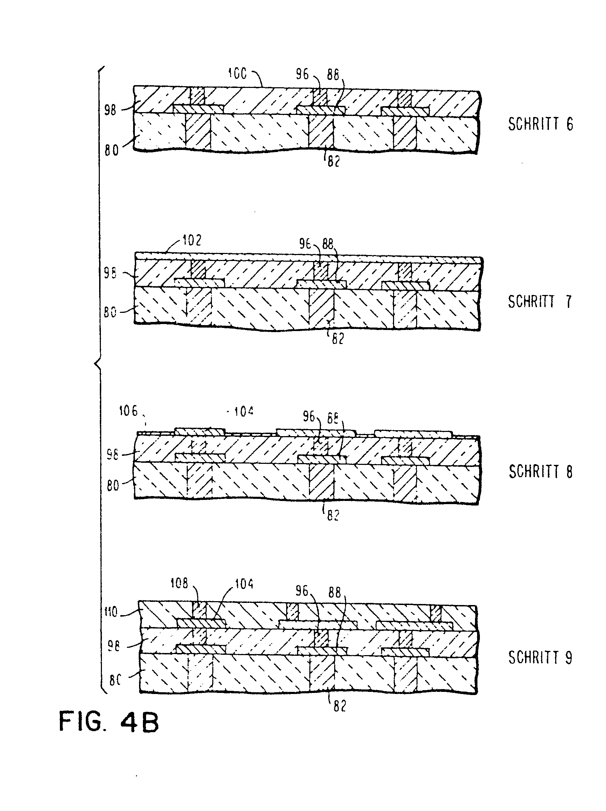

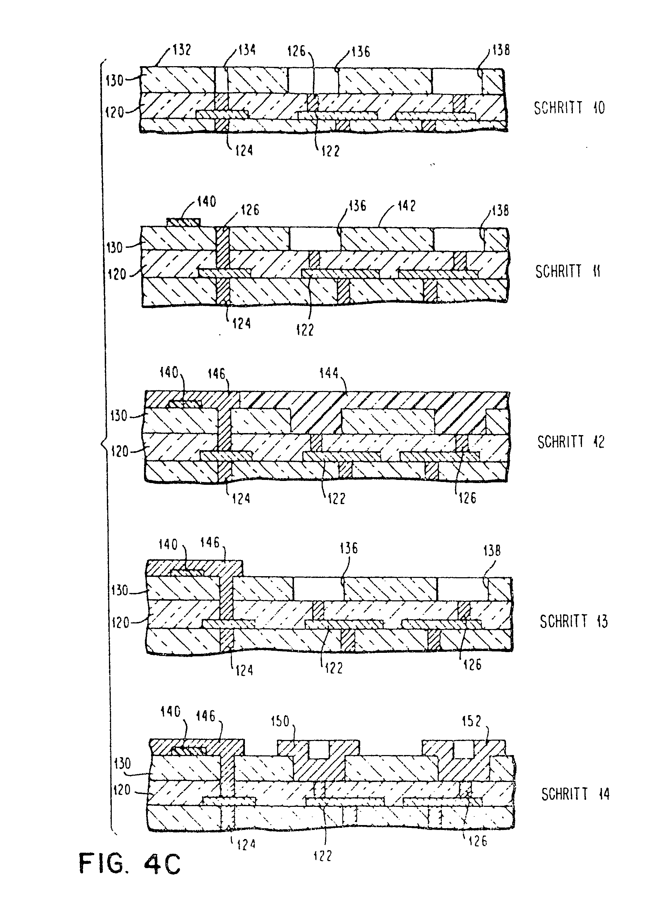

Fig. 4A, 4B und 4C zeigen das bevorzugte Verfahren für die Herstellung der in Fig. 1 und 2 dargestellten Glas-Keramik-Metall-Packung 30.

Ein vorgefertigter Glas-Keramik-Körper 80 mit
leitenden durchgehenden Bohrungen 82 wird auf
eine vorbestimmte Dicke geläppt. In der bevorzugten Ausführungsform ist die gesamte Dicke
der mehrschichtigen Glas-Keramik (30 in Fig. 1
und 2) etwa 0,13 mm ± 0,08 mm. Es ist dabei notwendig, die oben liegende Oberfläche 84 so weit
zu polieren, daß die Abweichungen von der ebenen Oberfläche nicht größer sind als 0,003 mm
bis 0,005 mm. Das Läppen kann mit einer freien
oder Bindeharz versehenen Schleifscheibe
durchgeführt werden, worauf der glaskeramische Körper gereinigt wird.

Es ist notwendig, daß die Verfahrensschritte
zum Niederschlagen von Glas auf der oberen
Oberfläche 84 von Verunreinigungen frei sind.
Nach dem Läppen wird eine 0,05prozentige Lösung aus einem nicht-ionischen Reinigungsmittel in Wasser zum Abspülen der Oberfläche 84
benutzt. Danach erfolgt eine Ultraschallreinigung und ein Spülen mit einem Reinigungsmittel, wie z. B. Isopropanol. Die Auswahl eines
nicht-ionischen Spülmittels ist von Bedeutung,
da dieses durch die keramische Oberfläche nicht
absorbiert wird und wegen seiner Löslichkeit in
der Isopropanol-Spülung leicht entfernt werden
kann.

In der bevorzugten Ausführungsform ist das
glaskeramische Substrat ein kristallisierbares
Glas, wie es in der oben erwähnten Zusammensetzung gezeigt ist. Andere Glaszusammensetzungen mit entsprechender Wärmeleitfähigkeit,
die dielektrischen Eigenschaften und Kristallisationsfähigkeit können ebenfalls verwendet werden.

### Schritt 2

Nach der Vorbereitung der Oberfläche 84 des
glas-keramischen Körpers 80 wird darauf eine alles überdeckende Metallisierungsschicht 86 niedergeschlagen. Dieser Niederschlag wird durch drei aufeinander folgende, getrennte Verdampfungsvorgänge von Chrom, Kupfer und Chrom erzielt. In der bevorzugten Ausführungsform besteht die Metallisierungsschicht 86 aus einer unten liegenden Chromschicht mit einer Stärke von etwa 80 nm, einer darüber liegenden Kupferschicht mit einer Stärke von etwa 3 µm und einer oben liegenden Chromschicht mit einer Stärke von etwa 80 nm.

Das Chrom wird als unten liegende Schicht deswegen ausgewählt, weil es besonders gut an glaskeramischen Oberflächen haftet. Die 3 µm starke Kupferschicht stellt die eigentlich elektrisch leitende Leitung dar, und ihre Abmessungen werden im wesentlichen von elektrischen konstruktiven Überlegungen bestimmt. Wiederum wird die 80 nm starke Chromschicht auf der Oberfläche deswegen ausgewählt, weil darauf die nächstfolgende glaskeramische Schicht sehr gut haftet.

### Schritt 3

Dieser zeigt die Ergebnisse einer selektiven Ätzung. Durch Auswahl geeigneter Ätzmittel erhält man das aus einer Anzahl von Leitungen 88 bestehende Metallisierungsmuster. Durch selektives Ätzen bleiben die Leitungen 88 übrig, die aus einer Schichtenfolge Chrom-Kupfer-Chrom bestehen, während in den abgeätzten Bereichen nur eine dünne Chromschicht 90 verbleibt. Diese dünne Chromschicht 90 wird im Schritt 4 als Kathode für einen Galvanisierungsvorgang zum Niederschlagen von Kupferstiften verwendet. Andererseits kann die hohe Auflösung der metallischen Leitungen durch Verwendung eines mit ablösbarem Photolack arbeitenden Elektronenstrahlverdampfungsverfahren erzielt werden, und ein typisches Leitungsmuster weist Leitungen mit einer Breite von 12 µm und einem Abstand zwischen den Leitungen von 12 µm auf.

### Schritt 4

Zum Niederschlagen leitender Stifte an bestimmten Punkten wird ein photolithographisches Material oder eine Photolackschicht 94 über dem Leitungsmuster mit den Leitungen 88 und der Chromschicht 90 aufgebracht. Zur Herstellung von Öffnungen an den bestimmten Punkten wird die Photolackschicht in üblicher Weise belichtet, entwickelt und abgelöst. Unter Verwendung der Chromschicht 90 als Kathode werden in den ausgewählten Öffnungen Kupferstifte 96 galvanisch niedergeschlagen. Die Dicke der Photolackschicht muß dabei größer sein als die später aufzubringende dielektrische Schicht, damit die Stifte ausreichend hoch gemacht werden können, damit sie den Anschluß an die nächste Ebene der Metallisierung durch die nächstfolgende dielektrische Schicht ermöglichen.

Nach der Galvanisierung der Stifte werden die Photolackschicht 94 und die als Kathode dienende Chromschicht 90 mit üblichen Verfahren entfernt.

### Schritt 5

Nach Entfernen der Photolackschicht 94 und der Chromschicht 90 wird eine Glastrübe auf dem glaskeramischen Substrat 80 zur Bildung einer Schicht 98 mit einer Dicke aufgetragen, die die Höhe der Stifte 96 merklich übersteigt. Die Trübe kann beispielsweise mit Hilfe einer Rakel oder durch Aufsprühen aufgebracht werden. Die Trübe besteht dabei aus einem Glaspulver mit einer durchschnittlichen Teilchengröße von 3 µm bis 5 µm, die in einem Trägermaterial, wie z. B. Terpineol suspendiert sind. Zur Verwirklichung der gewünschten physikalischen und dielektrischen Eigenschaften der isolierenden Glas-Keramik-Schicht ist es wichtig, daß die Glastrübe eine homogene und gleichförmige Dispersion bildet.

Die so aufgebrachte Glastrübe wird dann für etwa 15 bis 20 Minuten bei 125°C zum Austreiben des Trägermaterials getrocknet und dann für zwei Stunden in einer inerten Gasatmosphäre bei 780°C zum Sintern des Glases gebrannt und dann weiter in einer gasförmigen Atmosphäre, beispielsweise aus Stickstoff oder Argon, das in der Glasschicht 98 nicht löslich ist, für zwei Stunden bei 965°C für eine Kristallisation des Glases in eine Glaskeramik gesintert. Es sei außerdem darauf hingewiesen, daß, wenn die Gefahr der Oxidation besteht (beispielsweise bei Kupferleitungen), die Kristallisation des Glases in einer $H_2O/H_2$ Atmosphäre durchgeführt werden kann.

### Schritt 6

Nach Abkühlung der Schicht 98 muß die oberste Oberfläche vor den nachfolgenden Verfahrensschritten bearbeitet werden. Wie in Schritt 6 gezeigt, wird die oberste Oberfläche der Schicht 98 geläppt und zur ebenen Oberfläche 100 plangeschliffen. Dieser Läppvorgang erfüllt einen mehrfachen Zweck. Zunächst wird damit eine ebene Oberfläche erreicht und außerdem erhält man eine für nachfolgende photolithographische Verfahren notwendige Oberflächenbeschaffenheit. Außerdem ist dadurch eine genaue Einstellung der Dicke der Schicht 98 möglich, und schließlich werden dadurch die Stifte 96 freigelegt.

### Schritt 7

Nach der Behandlung der Schicht 98 zur Bildung der Oberfläche 100 werden nacheinander drei verschiedene Metallschichten durch Verdampfung aufgebracht, nämlich eine alles überdeckende Metallschicht 102, die aus einer Schichtenfolge von Chrom-Kupfer-Chrom besteht. Dieser Schritt ist mit dem bei Schritt 2 beschriebenen Verfahrensschritt identisch.

### Schritt 8

Hier ist die Herstellung der Metallisierung der Leitungszüge der zweiten Ebene beschrieben, die identisch mit dem Verfahrensschritt 3 abläuft. Dies hat zur Folge, daß man ein selektives Metallisierungsmuster 104 und eine als Kathode wirkende Chromschicht 106 erhält.

### Schritt 9

Anschließend werden mit den Schritten 4 bis 6 identische Verfahrensschritte durchgeführt, und damit wird eine zweite Schicht von Verbindungsleitungen niedergeschlagen, die aus einer zweiten Ebene eines metallisierten Leitungsmusters 104 und Stiften 108 der zweiten Ebene sowie einer glas-keramischen Isolierschicht 110 der zweiten Ebene besteht. Nach Schritt 9 kann das Verfahren so oft als nötig wiederholt werden, um damit die gewünschte Anzahl von Metallisierungsebenen herzustellen.

Es sei nochmals ausdrücklich darauf hingewiesen, daß das neuartige Verfahren gemäß der Erfindung die aufeinanderfolgende Herstellung von Schichten aus Glaskeramik und Metall möglich macht, ohne daß dabei die darunter liegenden Metallisierungsebenen irgendwie beeinträchtigt oder unterbrochen werden, was auf die Tatsache zurückzuführen ist, daß die Brenntemperatur nicht zu einem Fließen der darunterliegenden glaskeramischen Schichten führt. Weiter sei nochmals bemerkt, daß trotz der Tatsache, daß dieses neue Verfahren und die sich dabei ergebende Struktur bei einer Brenntemperatur hergestellt werden, bei der normalerweise eine Blasen aufweisende Glasschicht erzeugt würde, diese Schwierigkeit dadurch beseitigt wird, daß beim Brennen eine ganz bestimmte Gasatmosphäre benutzt wird.

In Fig. 4C sind nun die Verfahrensschritte 10 bis 14 dargestellt, mit deren Hilfe die oben liegende Oberfläche der Glas-Keramik-Metall-Packung hergestellt wird.

### Schritt 10

Der Verfahrensschritt 10 zeigt die unmittelbar unter der obersten Schicht liegende glaskeramische Schicht 120 mit einem darauf liegenden Metallisierungsmuster 122, das an unten liegenden Stiften 124 und oben liegenden Stiften 126 angeschlossen ist. Diese Teile werden wiederum gemäß dem in den Schritten 1 bis 9 beschriebenen Verfahren hergestellt.

Für die alleroberste Glasschicht 130 wird eine Glaszusammensetzung als Passivierungsmaterial ausgewählt, das andere Eigenschaften aufweist als die weiter unten liegenden Glasschichten. In der bevorzugten Ausführungsform wird zur Befestigung der Halbleiterplättchen auf der Metallisierung der obersten Ebene ein Lötrückflußverfahren eingesetzt. Im Schritt 10 besteht die glasartige Schicht 130 aus einem Glas mit hohem Silikatanteil und einem Wärmeausdehnungskoeffizienten, der an den des Substratmaterials angepaßt ist, oder es wird ein anderes dafür geeignetes glasartiges Material einschließlich kristallisierbarer Gläser durch Zerstäubung oder andere Verfahren auf der oben liegenden Glas-Keramik-Schicht 120 niedergeschlagen. Zum Aufbringen der obersten Schicht 130 werden übliche Quarz-Zerstäubungsverfahren eingesetzt. Nach dem Niederschlagen der Schicht 130 wird ihre Oberfläche 132 so behandelt, daß sie die entsprechenden Oberflächeneigenschaften aufweist, worauf dann die Öffnungen 134, 136 und 138 gebildet werden.

### Schritt 11

Als nächstes wird im Vakuum eine Metallisierung vorgenommen, durch die der linke obere Stift 126 bis an die Oberfläche der oberen aus Quarz bestehenden Schicht 130 erstreckt wird. Außerdem wird auf der oben liegenden Oberfläche 142 ein für Änderungen vorgesehenes Polster 140 selektiv niedergeschlagen. Dieses Polster 140 soll bei nachfolgenden Änderungen, wenn die gesamte Packung mit Halbleiterschaltungsplättchen besetzt ist, beim Auftrennen von Leitungszügen, Beschädigungen der darunter liegenden Schicht vermeiden helfen.

### Schritte 12 und 13

Anschließend wird eine Photolackmaske 144 auf der oberen Schicht 130 für die selektive Belichtung zur Herstellung der gewünschten Metallisierungsmuster aufgebracht. Dann wird selektiv ein Metallisierungsmuster 146 hergestellt. Die sich dabei ergebene Struktur zeigt Schritt 13. Wiederum kann das Metallisierungsmuster 146 aus einem geeigneten metallischen System bestehen und ist in der bevorzugten Ausführungsform aus einer Schichtfolge Chrom-Kupfer-Chrom aufgebaut.

### Schritt 14

Dieser zeigt das Niederschlagen eines Paares von Anschlußkontakten 150 und 152 für Halbleiterplättchen. In der bevorzugten Ausführungsform bestehen die Anschlußkontakte 150 und 152 aus einer Schichtfolge von Chrom—Kupfer—Gold. Obgleich hier nicht gezeigt, wird doch zur Befestigung der Haltleiterplättchen 24 auf ihren entsprechenden Anschlußkontakten 150 und 152 das bekannte Lötrückflußverfahren angewandt, wie es beispielsweise in den US-Patentschriften 3 374 110, 3 429 949 und 3 495 133 beschrieben ist (Flip-Chip-Technik).

In Fig. 5 ist eine weitere Ausführungsform für die Metallisierung der obersten Ebene gezeigt, wie sie anstelle des Schrittes 14 in Fig. 4B verwendet werden kann. Die oberste Glasschicht 160 enthält eine Anzahl galvanisch aufgebrachter Stifte 162. Eine Metallisierungsebene der unmittelbar darunter liegenden Glasschicht besteht aus Chrom-Kupfer-Chrom-Schichten 164, 166 und 168. In dieser Ausführungsform wird ein chromloses Ablöseverfahren auf die oberste Metallisierungsschicht angewandt.

Zunächst wird eine 150 nm dicke Kupferschicht, alles überdeckend, auf der oberen Oberfläche 170 der Glasschicht 160 aufgebracht. Anschließend wird durch ein Ätzverfahren eine Anzahl von Kupferkontakten hergestellt, von denen einer bei 172 gezeigt ist. Da Kupfer nicht so gut an Glas haftet wie Chrom, ist die Metallisierungsleitung an dieser Stelle unter Verwendung eines scharfen Instruments leicht auftrennbar, wenn immer selektiv eine Unterbrechung von Schaltelementen erwünscht ist.

Anschließend wird, alles überdeckend, eine Chromschicht, gefolgt von einer Kupferschicht, über der oberen Oberfläche niedergeschlagen. Dann werden durch eine selektive Ätzung die Metallisierung der Oberfläche und die Anschlußkontakte festgelegt. Die Chromschicht 173 und die Kupferschicht 174 stellen die Metallisierungsschichten dar, und die Chromschicht 175, Kupferschicht 176 geben die unten liegenden Metallisierungsschichten für die Anschlußkontakte für die Halbleiterplättchen.

Anschließend werden unter Verwendung einer Photolackmaske und der Chromschicht als Kathode (nicht gezeigt, jedoch zuvor besprochen) durch galvanisches Abscheiden Nickelschichten 178 und 179 aufgebracht.

Dann werden ebenfalls galvanisch unter Verwendung der gleichen Maske Goldschichten 182 und 184 aufgebracht. Dann werden das Photolackmaterial und die als Kathode dienende Chromschicht entfernt.

Eine aus einer Zinn-Blei-Legierung bestehende Schicht 187 wird anschließend durch eine Metallmaske nur an den Stellen der Anschlußkontakte für die Halbleiterplättchen aufgedampft. Schließlich wird ein Halbleiterplättchen 190, das Anschlußkontakte aufweist, auf die Anschlußkontakte aufgesetzt, und die Verbindung zwischen den beiden Anschlußkontakten wird in bekannter Weise durch Rückfließen von Lötmittel hergestellt.

**Patentansprüche**

1. Verfahren zum Herstellen einer in ihrer Wärmeleitfähigkeit angepaßten einstückigen Glaskeramik-Metallpackung mit in mehreren Ebenen angeordneten und selektiv miteinander verbundenen, im übrigen aber gegeneinander durch glaskeramische Schichten isolierten Metallisierungsmustern als Substrat für die Befestigung von mit integrierten Schaltungen versehenen Halbleiterplättchen durch

Herstellen eines aus keramischen Materials bestehenden Keramiksubstrates mit einer Anzahl von metallisierten und untereinander zu einem vorbestimmten Leitungsmuster verbundenen Leiterebenen, durch

Herstellen eines ersten Leitungsmusters auf der oberen Oberfläche des Substrates mit einem vorbestimmten Muster von Anschlüssen an die Leiterebenen,

Herstellen einer Anzahl leitender Stifte auf dieser Oberfläche und diesem metallisierten Leitungsmuster in einem vorbestimmten Muster von Anschlüssen an die Leiterebenen und das metallisierte Leitungsmuster,

Bilden einer Glasschicht auf der Oberfläche, Aufheizen der Glasschicht auf Sintertemperatur, und

Bearbeiten der glaskeramischen Schicht bis zum Freilegen der senkrechten leitenden Stifte an der Oberfläche der Schicht,

gekennzeichnet durch folgende Verfahrensschritte:

Herstellen des Keramiksubstrates aus einem glaskeramischen Material, das als hauptsächliche Bestandteile $\beta$-Spodumen oder $\alpha$-Cordierit enthält, und dessen Erweichungstemperatur im auskristallisierten Zustand oberhalb von 1373 K (1100° C) liegt,

Herstellen des ersten Leitungsmusters aus der Schichtenfolge Cr—Cu—Cr auf der oberen Oberfläche des Substrates mit einem vorbestimmten Muster von Anschlüssen an die Leiterebenen,

Bilden einer kristallisierbaren Glasschicht, deren hauptsächliche kristallisierbare Bestandteile $\beta$-Spodumen oder $\alpha$-Cordierit sind auf dieser Oberfläche,

Aufheizen und Sintern der kristallisierbaren Glasschicht bei 780° C in einer inerten Atmosphäre, und

Kristallisieren dieser gesinterten Glasschicht bei einer unter dem Schmelzpunkt des metallisierten Leitungsmusters und der Stifte liegenden Kristallisationstemperatur von etwa 965° C zu einer glaskeramischen Schicht.

2. Verfahren nach Anspruch 1, dadurch gekennzeichnet, daß die Leiterebenen in Dickschicht-Technik und die metallisierten Leitungsmuster in Dünnschicht-Technik ausgeführt werden.

3. Verfahren nach Anspruch 1, gekennzeichnet durch folgende weitere Verfahrensschritte:

Herstellen eines weiteren Leitungsmusters aus der Schichtenfolge Cr—Cu—Cr auf der oberen Oberfläche der glaskeramischen Schicht mit einem vorbestimmten Muster von Anschlüssen an die Leiterebenen,

Bilden einer weiteren kristallisierbaren Glasschicht, deren hauptsächliche kristallisierbare Bestandteile $\beta$-Spodumen oder $\alpha$-Cordierit sind, auf dieser Oberfläche,

Aufheizen und Sintern dieser weiteren kristallisierbaren Glasschicht bei 780°C in einer inerten Atmosphäre, und

Kristallisieren dieser weiteren gesinterten Glasschicht bei einer unter dem Schmelzpunkt des metallisierten Leitungsmusters und der Stifte liegenden Kristallisationstemperatur von etwa 965°C zu einer weiteren glaskeramischen Schicht,

wobei diese weiteren Verfahrensschritte entsprechend der Anzahl benötigten Metallisierungsebenen wiederholt werden.

4. Verfahren nach den Ansprüchen 1 bis 3, dadurch gekennzeichnet, daß für die Leiterebenen und die Metallisierungsebenen Kupfer, Gold oder Silber als metallische Grundlage verwendet wird.

## Claims

1. Method for fabricating a one-piece thermally compatible glass-ceramic/metal package with metallization patterns arranged in several planes and selectively interconnected but otherwise mutually insulated by glass-ceramic layers, as a substrate for holding semiconductor chips bearing integrated circuits, by manufacturing a substrate consisting of ceramic materials with a plurality of metallized conductive planes interconnected together in a predetermined pattern of conductors, by manufacturing a first conductor pattern on the top surface of the substrate, with a predetermined pattern of interconnections to the conductive planes, manufacturing a plurality of conductive studs on said surface and said metallized conductor pattern in a predetermined pattern of interconnection to the conductive planes and to the metallized conductor pattern, forming a glass coating on the surface, heating the glass coating to the crystallization temperature thereof and working said glass-ceramic coating down to the vertical conductive studs at the surface of said coating, characterized by the following steps:

forming a ceramic substrate from a glass-ceramic material comprising as its principal constituents β-spodumen or α-cordierite and the softening temperature of which in its crystallized state is above 1373 K (1100°C),

forming the first conductor pattern with a layer sequence of Cr—Cu—Cr on the top surface of the substrate, with a predetermined pattern of connectors to the conductor planes,

forming over said surface a crystallizable glass layer the principal constituents of which are β-spodumen or α-cordierite,

heating and sintering the crystallizable glass layer at 780°C in an inert atmosphere, and

crystallizing said sintered glass layer a crystallization temperature of about 965°C being below the melting point of the metallized conductive pattern and of said studs, to form a glass-ceramic layer.

2. Method according to claim 1, characterized in that the conductor planes are manufactured in thick-film techniques, whereas the metallized conductor patterns are manufactured in thin-film techniques.

3. Method according to claim 1, characterized by the following further steps:

manufacturing on the top surface of the glass-ceramic layer of a further conductor pattern habing a Cr—Cn—Cr layer sequence, having a predetermined pattern of connectors to the conductive planes,

forming a further crystallizable glass layer the main constituents of which are β-spodumen or .ι-cordierite,

heating and sintering of said further crystallizable glass layer at 780°C in an inert atmosphere, and

crystallizing said sintered glass layer at a crystallization temperature of about 965°C, i. e. below the melting point of the metallized conductive pattern and of the studs, to form a further glass-ceramic layer,

wherein these further process steps are repeated in accordance with the number of metallization planes required.

4. Method according to claim 1 through 3, characterized in that for the conductor planes and the metallization planes, copper, gold or silver are used as a metallic base structure.

## Revendications

1. Procédé pour fabriquer un empilage monobloc vitrocéramique-métal dont la conductibilité thermique est adaptée et qui comporte des modèles de métallisations disposés dans plusieurs plans et reliés sélectivement entre eux, mais isolés par ailleurs les uns par rapport aux autres par des chouches vitrocéramiques, et servant de substrat pour la fixation de microplaquettes à semiconducteurs munies de circuits intégrés, moyennant la fabrication d'un substrat céramique constitué en un matériau céramique et comportant un nombre de plans de conducteurs métallisés et reliés entre eux pour former un modèle de lignes prédéterminé, la fabrication d'un premier modèle de lignes sur la surface supérieure du substrat selon une configuration prédérminée de raccordements aux plans de conducteurs, la fabrication d'un nombre de broches conductrices sur cette surface et sur ce modèle de lignes métallisé, selon une configuration prédéterminée de raccordements aux plans de conducteurs et au modèle de lignes métallisé, la formation d'une couche de verre sur la surface, le chauffage de la couche de verre à la température de frittage et le traitement de la couche vitrocéramique jusqu'au dégagement des broches conductrices verticales sur la surface de la couche, caractérisé par les phases opératoires suivantes: fabrication du substrat céramique avec un matériau vitrocéramique, qui contient comme éléments constitutifs principaux du β-spodumène ou de la .ι-cordiérite et dont la température de ramollissement se situe, à l'état cris- rallisé, à une valeur supérieure à 1373°K (1100°C), fabrication du premier modèle de lignes formé de la suite de couches Cr—Cu—Cr sur la surface supérieure du substrat selon une configuration prédéterminées de raccordements aux plans de conducteurs, formation d'une couche de verre cristallisable, dont les éléments constitutifs cristallisables principaux sont le $\beta$-spodumène ou la $\alpha$-cordiérite, sur ladite surface, chauffage et frittage de la couche de verre cristallisable à 780°C dans une atmosphère inerte et cristallisation de cette couche de verre frittée à une température de cristallisation d'environ 965°C, inférieure au point de fusion du modèle de lignes métallisé et des broches, pour former une couche vitrocéramique.

2. Procédé selon la revendication 1, caractérisé en ce que les plans de conducteurs sont réalisé selon la technique à couches épaisses et que le modèle métallisé de lignes est réalisé selon la technique à couches minces.

3. Procédé selon la revendication 1, caractérisé par les phases opératoires supplémentaires suivantes: fabrication d'un autre modèle de lignes, constitué par la succession de couches Cr—Cu—Cr sur la surface supérieure de la couche virocéramique, avec une configuration prédérminée de raccordements aux plans de conducteurs, formation d'une autre couche de verre cristallisable, dont les éléments constitutifs cristallisables principaux sont le $\beta$-spodumène ou la $\alpha$-cordiérite, sur ladite surface, chauffage et frittage de ladite autre couche de verre cristallisable à 780°C dans une atmosphère inerte et cristallisation de l'autre couche de verre fritté à une température de cristallisation d'environ 965°C, inférieure au point de fusion du modèle de lignes métallisé et des broches, pour former une autre couche vitrocéramique, ces phases opératoires supplémentaires étant répétées conformément au nombre de plans nécessaires de métallisations.

4. Procédé selon les revendications 1 à 3, caractérisé en ce que l'on utilise du cuivre, de l'or ou de l'argent comme élément de base métallique pour les plans de conducteurs et les plans de métallisations.

FIG. 1

FIG. 2

**FIG. 3**

**FIG. 5**

FIG. 4A

SCHRITT 6

SCHRITT 7

SCHRITT 8

SCHRITT 9

FIG. 4B

FIG. 4C